# EUROPEAN PATENT SPECIFICATION

(11) **EP 0 726 700 B1**
(45) Date of publication and mention of the grant of the patent: **17.03.1999**
(21) Application number: 96300392.6
(22) Date of filing: 19.01.1996
(51) Int. Cl.: H05K 9/00

(54) **A shielding device**
Abschirmungsvorrichtung
Dispositif de blindage

(30) Priority: 07.02.1995 GB 9502375
(43) Date of publication of application: 14.08.1996
(73) Proprietor: NOKIA MOBILE PHONES LTD., 24101 Salo (FI)
(72) Inventor: Davidson, Brian James, Woking, Surrey GU21 3QD (GB)
(74) Representative: Haws, Helen Louise

(56) References cited:
- DE-A- 3 325 360
- US-A- 4 890 199
- US-A- 5 354 951

## Description

This invention relates to a shielding device for use in radio telephones, preferably for the shielding of electronic components on a circuit board.

Radio telephones are required by law to adhere to ElectroMagnetic Compatibility (EMC) limits as laid down in Type Approval Specifications for Mobile Phones. EMC is defined as the ability of a device to function properly in its intended electromagnetic environment and not to be a source of electromagnetic pollution to that environment.

To enable electronic apparatus to be electromagnetically compatible, electromagnetic (EM) shielding is often placed within the apparatus to reduce the radiation emissions from radiating sources and to reduce the levels of radiation reaching sensitive components.

In general, EM shields take the form of metal or metallised plastic covers designed to be placed over electronic components on a circuit board. To prevent the passage of radiation towards or away from the electronic components the shields are electrically grounded, typically using the grounding planes present on the circuit board. The most common way of attaching the shields to the circuit board and particularly to the grounding planes is by soldering. This provides a semi-permanent fixing that may only be removed by de-soldering.

Ordinarily, during the production of radio telephones the electronic components are firstly mounted onto the circuit board. EM shields are then placed over the components and secured using soldering techniques that may also provide electrical coupling to ground. The circuit board supporting the electronic components and the shield can then be tested. A percentage of circuit boards inevitably fail the tests and inspection and repair of the electronic components is usually required. Similarly, units which pass the tests and subsequently become faulty for any reason may also require inspection and repair.

Current soldered shield designs have a disadvantage in that the inspection and repair of soldered electronic components is blocked by the presence of the EM shield casings. To inspect and repair the electronic components the shields must be de-soldered, the inspection and repair carried out and then the shields must be re-soldered. De-soldering and re-soldering is laborious and creates a risk of damage to electronic components within the region of the shield.

Other known shielding devices such as US 4,890,199 have the EM shield casing attached to the circuit board using one or more gaskets which allow removal of the shield casing during repair. These gaskets are, however, generally complex in structure and have to be mounted individually onto the circuit board during construction of the shield. Consequently manufacturing cost and time are increased using this method.

Other known shielding devices include US 535 4951 which shows an EMI shielding assembly made of electrically conductive material, having plurality of interconnected walls and a cover, and DE 332 5360 which shows a housing for a tuning device.

According to the invention as defined in claim 1 there is provided a shielding device for inhibiting the passage of electromagnetic radiation to and from circuit elements disposed on a substrate surface wherein said shielding device is a unitary member constructed from a single planar sheet, comprising first and second integral portions, said first portion being adapted for mounting the shielding device on a substrate surface and for providing side walls (4), wherein adjacent side walls are formed by the selective bending of pre-defined areas of the planar sheet along respective axes, said axes being defined areas of the planar sheet along respective axes, said axes being substantially parallel to each other, and said second portion providing a lid of the shielding device, said lid being displaceable about another axis joining said lid and a side wall, between a closed position wherein the components disposed on the substrate surface are covered, and an open position wherein access to the components disposed on the substrate surface is facilitated.

A shielding device in accordance with the invention has the advantage that it is displaceable between an open and a closed position. Substantial electromagnetic shielding is provided in the closed position and access to circuit elements beneath the shield is provided in the open position. The action required to move the shielding device from the closed position to the open position does not involve de-soldering. Thus a simpler and less time-consuming solution is provided in circumstances where, for example, electronic components mounted on a circuit board beneath the shielding device require inspection and repair.

Another advantage given by a shielding device in accordance with the invention is that only one component, the unitary planar element, is required to make the shielding device. As a consequence a cheaper solution is obtained which requires less assembling time and is generally less complex.

A shielding device manufactured by folding a unitary planar member has a number of advantages over other designs that use, for example, casting techniques. Firstly this type of manufacture is ideally suited to mass production methods where speed, consistency and low running costs are required. Secondly the design and production of the shield device in accordance with the invention can be easily modified to make shields of different shapes or sizes.

In a preferred embodiment the second portion of the shielding device is a cover displaceable by movement about its connection with the first portion. An advantage of using this system is that the shield can be simply hinged open or closed.

The shielding device is preferably made from a metal or a metal alloy, suitably, for example, nickel silver. This material provides good EM shielding and is suitable for folding processes. Also this material has a high degree of resistance to corrosion.

In a preferred embodiment two portions of the shielding device are respectively a side wall member and a lid with depending flanges. The flanges help to improve the shielding provided when closed. Also the flanges can be biased so that they are forced against and grip sections of the lower portion. Projections disposed on the flanges produce increased forces at the contact points with the first section which results in a good electrical contact between the first and second portions for good EM shielding. Complementing recesses which engage with the projections may be included on the first section of the shielding device which gives a method of fastening closed the second section.

Additional strength is provided to the shield when the lid is closed by positioning adjacent flanges alternately inside and outside of the side wall member.

Embodiments of the invention will now be described, by way of example, with reference to the accompanying drawings, in which:
Figure 1 is a diagram of a shielding device in accordance with the invention in an open position;
Figure 2 is a diagram of the shielding device of figure 1 in accordance with the invention in a closed position;
Figure 3 is a diagram of a template for constructing the shielding device of figures 1 and 2;
Figure 4 is an exploded view of a shielding device mounted onto a substrate;
Figure 5 is a plan view and auxiliary projections of a shielding device in accordance with the invention; and
Figure 6 is a cross-sectional view of the edge of the shielding device of figure 5 in a closed position.

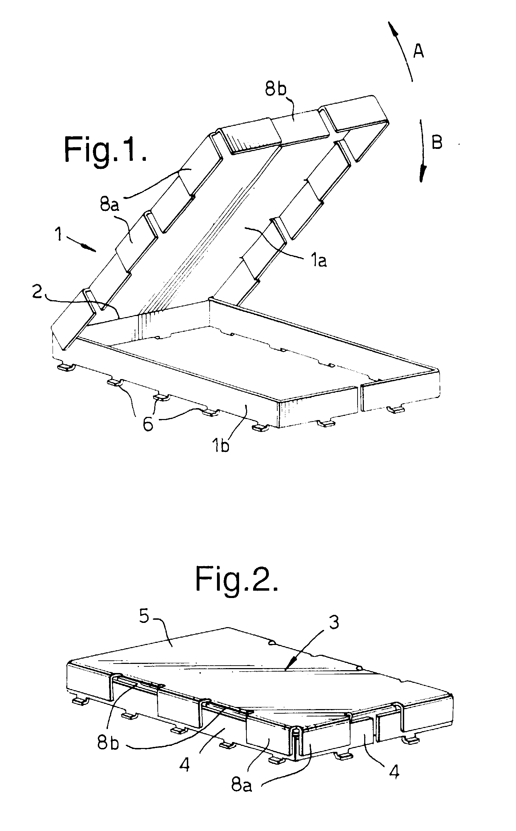

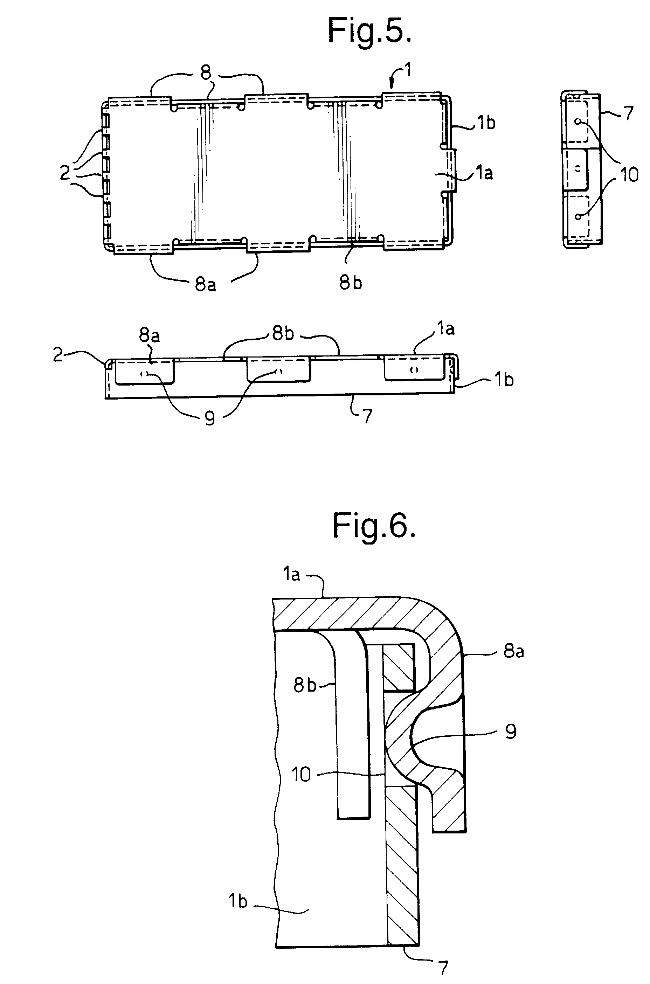

Referring to Figure 1 there is shown a shielding device 1 in accordance with the invention. The shielding device 1 comprises an upper portion 1a and a lower portion 1b interconnected along an edge 2. The edge 2 is formed such that it provides a hinge by which the upper portion 1a may achieve rotational motion relative to the lower portion 1b as shown by arrows A and B. The edge 2 may be continuous as shown in Figure 1 or it may be perforated as shown in Figure 5.

Upon moving the upper portion 1a in the direction of arrow B the shielding device 1 reaches the closed position as shown in Figure 2. In the closed position the shielding device 1 resembles a standard shield in the form of a box 3 for inhibiting the passage of EM radiation in which the lower portion provides side walls 4 and the upper portion a lid 5.

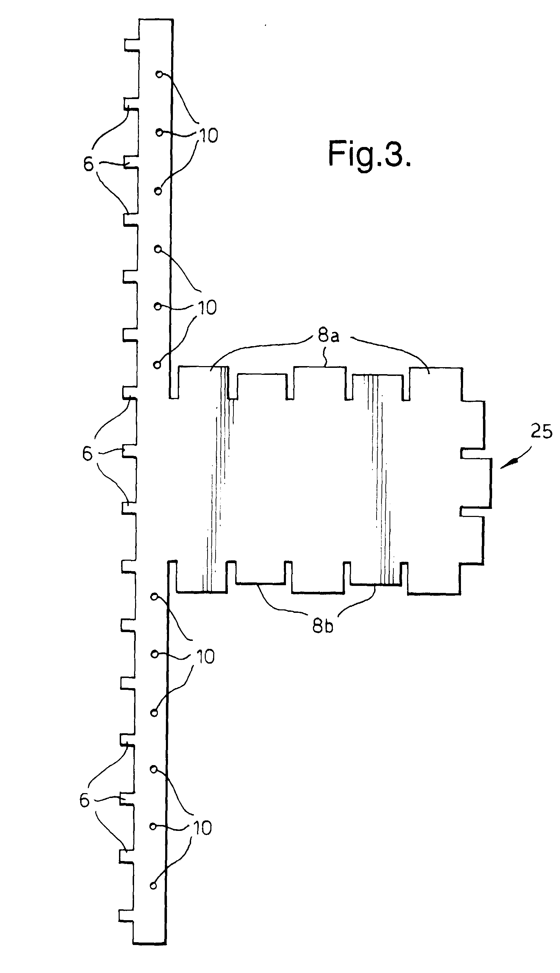

Referring also to Figure 3 there is shown a template 25 made of, for example, sheet metal, cut into a specific shape. By bending the planar sheet 25 along predetermined lines, the shielding device shown in Figures 1 and 2 may be constructed.

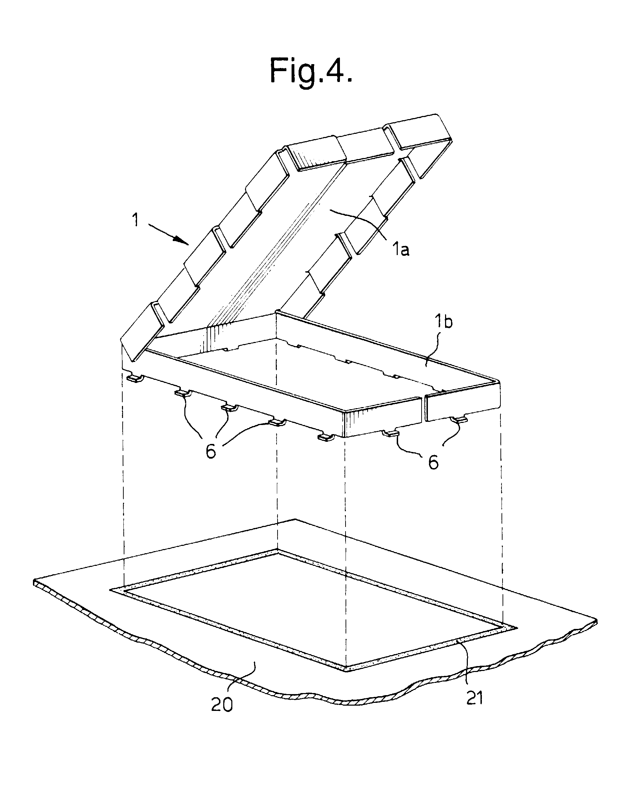

The shielding device 1 is designed to be mounted onto a substrate 20 as shown in an exploded view in Figure 4. For clarity Figure 4 shows the shielding device 1 being mounted whilst in the open position. It is likely, however, to be more suitable for the shielding device 1 to be mounted whilst in the closed position. In the embodiment shown the shielding device 1 is provided with feet 6 which may be used as soldering points for soldering the lower portion 1b onto a grounding plane 21 of the substrate 20. Another embodiment, shown in Figure 5, omits the use of feet which then allows the shielding device 1 to be mounted onto the substrate by, for example, seam soldering the lower edge 7 to the grounding plane 21.

The lid 5 of the shielding device has flanges 8 which extend from its outer edges. These flanges 8 depend from the lid 5 so that they point generally downwards. Two types of flanges exist in the embodiments described, a first type 8a that fit over the outside of the side walls 4 and a second type 8b that fit inside the side walls 4 when the lid is closed as shown in Figures 2 and 5.

The flanges can be biased for contact with the side walls 4 so that the upper portion grips the lower portion in the closed position. This improves the electrical contact between the two portions. Additionally, by having flanges that are alternately positioned inside and outside of the side walls, extra stability is provided to the side walls and hence to the entire structure.

The surfaces of some of the flanges that contact the side walls are provided with dome shaped projections 9 which may be formed using a metal punch. In the fully closed position the projections 9 abut the contact surfaces of the side walls 4. The biasing action of the flanges helps the projections to maintain an increased force on the side walls thus providing a further gripping action and a good electrical contact between the upper and lower portions in the closed position.

Referring to Figure 5 the lower portion 1b includes apertures 10 cut out of the side walls. These apertures 10 are positioned to complement the projections 9. When the shielding device is in the fully closed position the projections are urged into the holes by the biasing of the flanges 8 as shown in Figure 6. Consequently the projections mate with the holes to retain the shielding device in the closed position.

To gain access to electrical components on the substrate surface 20 (not shown), the shielding device must be moved to the open position. This is achieved by moving the upper portion in the direction of arrow B as shown in Figure 1. The process of moving the upper portion may be performed by, for example, applying an upwards force on one of the flanges opposite the hinge. The lid 5 may be provided with an aperture or other means by which a tool can be used to lift it from the closed position.

In view of the foregoing description it will be evident to a person skilled in the art that various modifications may be made within the scope of the invention.

## Claims

1. A shielding device (1) for inhibiting the passage of electromagnetic radiation to and from circuit elements disposed on a substrate surface (20) wherein said shielding device is a unitary member constructed from a single planar sheet (25), comprising first and second integral portions,
said first portion (1b) being adapted for mounting the shielding device (1) on a substrate surface (20) and for providing side walls (4), wherein adjacent side walls are formed by the selective bending of pre-defined areas of the planar sheet along respective axes, said axes being substantially parallel to each other, and
said second portion (1a) providing a lid of the shielding device, said lid being displaceable about another axis (2) joining said lid and a side wall, between a closed position wherein the components disposed on the substrate surface are covered, and an open position wherein access to the components disposed on the substrate surface is facilitated.

2. A shielding device as claimed in claim 1, wherein a plurality of flanges (8a, 8b) depend from the lid (5).

3. A shielding device as claimed in claim 2, wherein at least one of the flanges (8a) is arranged for disposition outside the side wall member (4) in the closed position.

4. A shielding device as claimed in claim 2 or claim 3, wherein at least one of the flanges (8b) is arranged for disposition inside the side wall member (4) in the closed position.

5. A shielding device according to claim 3 or claim 4, wherein at least one of the flanges (8a, 8b) is biased for contact with the side wall member in the closed position.

6. A shielding device as claimed in any of claims 2 to 5, wherein at least one of the plurality of flanges (8a, 8b) includes a projection (9) extending towards a contact surface of the side wall member (4) in the closed position for improving electrical conduction between the lid (5) and the side wall member (4) of the shielding device.

7. A shielding device as claimed in claim 6, wherein the side wall member (4) comprises a recess (10) for accommodating at least one of the projections (9) on the flanges (8a, 8b)in the closed position.

8. A shielding device as claimed in claim 7, wherein the recess (10) is an aperture.

9. A shielding device as claimed in any preceding claim, wherein the shielding device is made from a metal or a metal alloy.

## Patentansprüche

1. Abschirmungsvorrichtung (1) zur Vermeidung des Durchgangs elektromagnetischer Strahlung in Richtung von Schaltungselementen, die auf einer Substratoberfläche (20) angeordnet sind, und zur Vermeidung des Durchgangs elektromagnetischer Strahlung, die von den Schaltungselementen kommt, wobei
die Abschirmungsvorrichtung als ein aus einer einzelnen ebenen Platte (25) hergestelltes einheitliches Element mit ersten und zweiten integrierten Bereichen ausgebildet ist;
der erste Bereich (1b) zur Montage der Abschirmungsvorrichtung (1) auf einer Substratoberfläche (20) und zur Bereitstellung von Seitenwänden (4) dient, wobei benachbarte Seitenwände durch selektives Biegen vordefinierter Bereiche der ebenen Platte entlang jeweiliger im wesentlichen parallel zueinander verlaufender Achsen gebildet werden, und
der zweite Bereich (1a) einen Deckel der Abschirmungsvorrichtung zur Verfügung stellt, der über eine andere den Deckel und eine Seitenwand verbindende Achse (2) umlegbar ist, und zwar zwischen einer geschlossenen Stellung, in der die auf der Substratoberfläche angeordneten Komponenten abgedeckt werden, und einer offenen Stellung, in der ein Zugang zu den auf der Substratoberfläche angeordneten Komponenten ermöglich wird.

2. Abschirmungsvorrichtung nach Anspruch 1, bei der vom Deckel (5) eine Mehrzahl von Flansche (8a, 8b) abhängen.

3. Abschirmungsvorrichtung nach Anspruch 2, bei der in geschlossener Stellung mindestens einer der Flansche (8a) außerhalb des Seitenwandglieds (4) angeordnet ist.

4. Abschirmungsvorrichtung nach Anspruch 2 oder 3, bei der in geschlossener Stellung mindestens einer der Flansche (8b) innerhalb des Seitenwandglieds (4) angeordnet ist.

5. Abschirmungsvorrichtung nach Anspruch 3 oder 4, bei der in geschlossener Stellung mindestens einer der Flansche (8a, 8b) zum Kontakt mit dem Seitenwandglied vorgespannt ist.

6. Abschirmungsvorrichtung nach irgendeinem der Ansprüche 2 bis 5, bei der mindestens einer der Mehrzahl der Flansche (8a,8b) einen Vorsprung (9) aufweist, der sich bei geschlossener Stellung in Richtung einer Kontaktoberfläche des Seitenwandglieds (4) erstreckt, um die elektrische Verbindung zwischen dem Deckel (5) und dem Seitenwandglied (4) der Abschirmungsvorrichtung zu verbessern.

7. Abschirmungsvorrichtung nach Anspruch 6, bei der in geschlossener Stellung das Seitenwandglied (4) eine Ausnehmung (10) zur Aufnahme von mindestens einem der Vorsprünge (9) auf den Flanschen (8a,8b) enthält.

8. Abschirmungsvorrichtung nach Anspruch 7, bei der die Ausnehmung (10) als Öffnung ausgebildet ist.

9. Abschirmungsvorrichtung nach irgendeinem der vorangegangenen Ansprüche, wobei die Abschirmungsvorrichtung aus Metall oder einer Metallegierung hergestellt ist.

## Revendications

1. Dispositif de blindage (1) destiné à empêcher le passage de radiations électroniques allant vers les éléments de circuit et provenant de ceux-ci, et disposé sur une surface de substrat (20), dans lequel ledit dispositif de blindage est un élément unitaire construit à partir d'une feuille plane unique (25), comprenant une première et une seconde parties d'un seul tenant.
ladite première partie (1b) étant conçue pour le montage du dispositif de blindage sur une surface de substrat (20) et pour obtenir des parois latérales (4), dans laquelle les parois latérales adjacentes sont formées par le pliage sélectif de zones prédéfinies de la feuille plane le long des axes respectifs, lesdits axes étant sensiblement parallèles l'un par rapport à l'autre, et
ladite seconde partie (la) permettant d'obtenir un couvercle du dispositif de blindage, ledit couvercle pouvant être déplacé autour d'un autre axe (2) reliant ledit couvercle et une paroi latérale, entre une position fermée dans laquelle les composants disposés sur la surface de substrat sont recouverts, et une position ouverte dans laquelle l'accès aux composants disposés sur la surface de substrat est facilitée.

2. Dispositif de blindage selon la revendication 1. dans lequel une pluralité d'ailettes (8a, 8b) sont suspendues au couvercle (5).

3. Dispositif de blindage selon la revendication 2, dans lequel au moins l'une des ailettes (8a) est agencée pour être disposée à l'extérieur de l'élément formant paroi latérale (4) dans la position fermée.

4. Dispositif de blindage selon la revendication 1 ou la revendication 2, dans lequel au moins l'une des ailettes (8b) est agencée pour l'installation à l'intérieur de l'élément formant paroi latérale (4) dans la position fermée.

5. Dispositif de blindage selon la revendication 3 ou la revendication 4, dans lequel au moins l'une des ailettes (8a, 8b) est sollicitée pour venir en contact avec l'élément formant paroi latérale dans la position fermée.

6. Dispositif de blindage selon l'une quelconque des revendications 2 à 5, dans lequel au moins l'une des ailettes de la pluralité d'ailettes (8a, 8b) comprend un bossage (9) s'étendant vers une surface de contact de l'élément formant paroi latérale (4) dans la position fermée pour améliorer la conductivité électrique entre le couvercle (5) et l'élément formant paroi latérale (4) du dispositif de blindage.

7. Dispositif de blindage selon la revendication 6, dans lequel l'élément formant paroi latérale (4) comprend une encoche (10) destinée à loger au moins l'un des bossages (9) qui se trouvent sur les ailettes (8a, 8b) dans la position fermée.

8. Dispositif de blindage selon la revendication 7, dans lequel l'encoche (10) est une ouverture.

9. Dispositif de blindage selon l'une quelconque des revendications précédentes, dans lequel le dispositif de blindage est à base d'un métal ou d'un alliage de métaux.
